# EUROPEAN PATENT APPLICATION

(11) **EP 1 783 504 A1**
(43) Date of publication of application: **09.05.2007**
(21) Application number: 04772649.2
(22) Date of filing: 26.08.2004
(51) Int. Cl.: G01R 31/316

(54) **SEMICONDUCTOR TEST SYSTEM**

(71) Applicant: Test Research Laboratories Inc., Nagasaki-shi Nagasaki 851-0122 (JP)
(72) Inventor: TANAKA, Yoshito c/o Test Research Laboratories Inc, Nagasaki-shi Nagasaki 8510122 (JP)
(74) Representative: Vossius & Partner
(86) International application number: PCT/JP2004/012693
(87) International publication number: WO 2006/022026

(57) **Abstract**

There are included a mother board (11), which has therein a multiplexer and a test pass/fail determining part, and a daughter board (12) that has therein an A/D converting part and an averaging part. The mother board (11) multiplexes a plurality of analog signals outputted from a plurality of output terminals of an LSI formed on a wafer (W) to be tested, thereby reducing the number of signals in an early stage. The daughter board (12) A/D converts and averages the resultant signals from the mother board (11), and supplies the averaged characteristic measured data to the mother board (11) for a pass/fail determination. This can eliminate the need for a large number of parallel transmission paths and processing circuits, raise the throughput, and reduce the affections of noise included in the analog signals due to the average processing.

## Description

### [Technical Field]

The present invention relates to a semiconductor test system. Particularly, the present invention is suitably applied to a test system for testing electric characteristics of a super multi-pin output LSI.

### [Background Art]

In display apparatuses, such as liquid crystal displays, organic EL displays, plasma displays and field emission displays, image data are processed in an electronic circuit, such as a drive circuit, and outputted from a plurality of output terminals of the drive circuit to display elements. Since the electric characteristics of drive transistors disposed corresponding to the output terminals of the drive circuit and components of the electronic circuit vary to no small extent, the signal values outputted from the output terminals vary accordingly. Therefore, it is necessary to provide a test apparatus (test system) that measures relative errors and absolute errors of the signal values outputted from the output terminals to sort out defective products.

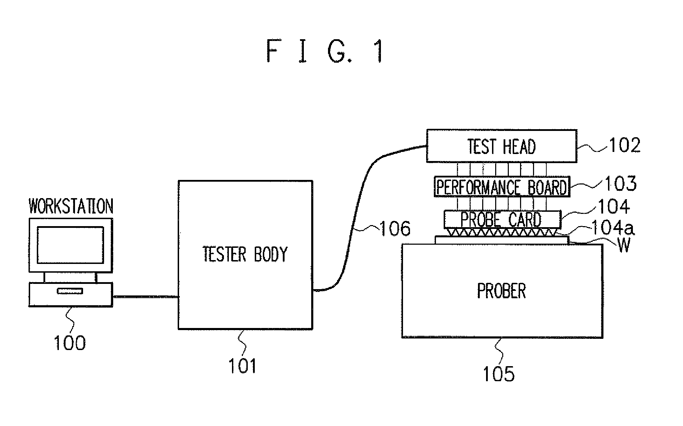

Figure 1 is a simplified diagrammatic view showing a conventional test system for testing an LSI formed on a wafer W. As shown in Figure 1, the conventional test system includes a workstation 100, a tester body 101, a test head 102, a performance board 103, a probe card 104 and a prober 105. The probe card 104 has a plurality of probe needles 104a disposed thereon.

The wafer W to be tested is placed on a chuck (not shown) formed on the prober 105, and the probe needles 104a of the probe card 104 are moved to touch input/output terminals of the LSI formed on the wafer W. The probe card 104 is connected to the test head 102 via the performance board 103, and the test head 102 is connected to the tester body 101 via a cable 106.

The test head 102 performs preprocessing, such as amplifying the signal outputted from each of the output terminals of the LSI and inputted via the probe card 104 and the performance board 103 and converting the inputted signal into digital data. The preprocessing is carried out by a front-end card removably attached to the test head 102. The tester body 101 performs pass/fail judgment of the LSI formed on the wafer W according to a test program stored therein and based on the characteristic measurement data sent via the test head 102. Postprocessing including the pass/fail judgment is carried out by a module removably attached to the tester body 101.

The performance board 103 is electrically connected to the test head 102 and the probe card 104 in a removable manner. By exchanging the module in the tester body 101, the front-end card in the test head 102 and the performance board 103 according to the LSI to be tested, LSIs designed in different standards can be handled in a flexible manner.

A test of a semiconductor circuit that outputs image signals from a large number of pins (a representative example of this is a drive LSI for a display apparatus) involves a large number of output values to be measured. To improve the throughput, it is necessary to perform parallel processing, such as simultaneous measurement of the output values. To this end, there has been conventionally provided a multi-pin test system in which the number of the probe needles 104a disposed on the probe card 104 corresponds to the number of output terminals (pins) of the drive LSI.

However, recent drive LSIs have been designed in an increasingly dense manner, so that it is necessary to dispose more than 1000 probe needles (pins) 104a on the probe card 104. When the number of pins is 1000, signals corresponding to 1000 pins are handled in parallel among the tester body 101, the test head 102, the performance board 103 and the probe card 104. Thus, such a multi-pin test system has a significantly large-scale configuration.

To eliminate such inconvenience, there has been proposed a technology in which signals outputted from a plurality of output terminals of a drive LSI are separately outputted to the outside from test terminals provided at the rate of one for every predetermined number of the output terminals (see Japanese Patent No. 3199827, for example).

According to Japanese Patent No. 3199827, switches are disposed between each of the test terminals and the predetermined number of output terminals, and the switch successively and selectively outputs the image signal delivered to the output terminal to the test terminal. In such configuration, the test can be performed by using the image signals outputted from the test terminals whose number is smaller than the large number of output terminals. It is accordingly possible to handle super multi-pin drive LSIs.

However, when the technology described in Japanese Patent No. 3199827 is used, the image signals delivered to the large number of output terminals are successively outputted via the test terminals. This requires longer test time than simultaneously measuring all output values, disadvantageously resulting in corresponding increased test cost. Furthermore, when the technology described in Japanese Patent No. 3199827 is used, the output signal from the test terminal is an analog signal, so that noise components are easily superimposed on the output signal and it is hence difficult to perform highly accurate testing.

### [Disclosure of the Invention]

The present invention has been made to solve such problems and aims to provide a small-scale test system capable of testing electric characteristics of a super multi-pin output LSI in a quick and highly accurate manner.

To solve the above problems, the semiconductor test system according to the present invention multiplexes a plurality of analog signals outputted from a plurality of output terminals of a semiconductor to be tested in an early stage to reduce the number of signals, performs A/D conversion, averaging and calibration on the resultant multiplexed signal and supplies the calibrated characteristic measurement data to a semiconductor pass/fail judgment section.

According to the thus configured present invention, since the plurality of analog signals outputted from the plurality of output terminals are multiplexed to reduce the number of signals in an early stage and data are averaged in an early stage after the A/D conversion to reduce the amount of data, a large number of parallel transportation paths and processing circuits are not required, allowing reduction in the size of the apparatus. Furthermore, the number of signals and the amount of data are thus reduced, allowing improved throughput, faster processing and significant reduction in test time. Moreover, since data sampled multiple times are averaged and calibrated for the following pass/fail judgment, the effects of random noise and systematic noise superimposed on the data are reduced, allowing high accuracy testing. By using a high operation speed multiplexer and A/D converter, the number of sampling in a short period of time can be increased for averaging, allowing higher testing accuracy.

In another aspect of the present invention, a primary pass/fail judgment is performed based on characteristic measurement digital data obtained by A/D converting a plurality of analog signals outputted from a plurality of analog output terminals of a semiconductor. Then, secondary pass/fail judgment is performed based on the digital data that have passed the primary pass/fail judgment.

According to the thus configured present invention, the following advantages are provided in addition to those described above. That is, according to the present invention, only digital data that have passed the primary pass/fail judgment undergo the secondary pass/fail judgment. This reduces the amount of digital data to be sent to the secondary judgment processor, allowing improved throughput, faster processing and significant reduction in test time.

In another aspect of the present invention, digital signals outputted from a plurality of output terminals of a semiconductor to be tested are T/D converted, averaged and calibrated, and the calibrated characteristic measurement data are supplied to a semiconductor pass/fail judgment section.

According to the thus configured present invention, since the digital signals outputted from the plurality of output terminals are T/D converted and averaged in an early stage after the T/D conversion to reduce the amount of data, a large number of parallel transportation paths and processing circuits are not required, allowing reduction in the size of the apparatus. Furthermore, the reduced amount of data allows improved throughput, faster processing and significant reduction in test time. Moreover, since data sampled multiple times are averaged and calibrated for the following pass/fail judgment, the effects of random noise and systematic noise superimposed on the data are reduced, allowing high accuracy testing.

### [Brief Description of the Drawings]

Figure 1 shows a simplified configuration of a conventional test system for testing an LSI formed on a wafer;
Figure 2 shows an exemplary schematic configuration of the entire test system according to first to fifth embodiments;
Figure 3 is a block diagram showing an exemplary inner configuration of the mother board and the daughter board according to the first embodiment;
Figure 4 is a block diagram showing an exemplary schematic configuration of the multiplexer according to the first, second and fifth embodiments;
Figure 5 is a block diagram showing an exemplary inner configuration of the mother board and the daughter board according to the second embodiment;
Figure 6 is a block diagram showing an exemplary inner configuration of the mother board and the daughter board according to the third embodiment;
Figure 7 is a block diagram showing an exemplary inner configuration of the mother board and the daughter board according to the fourth embodiment; and
Figure 8 is a block diagram showing an exemplary inner configuration of the mother board and the daughter board according to the fifth embodiment.

### [Best Mode for Carrying Out the Invention]

### (First Embodiment)

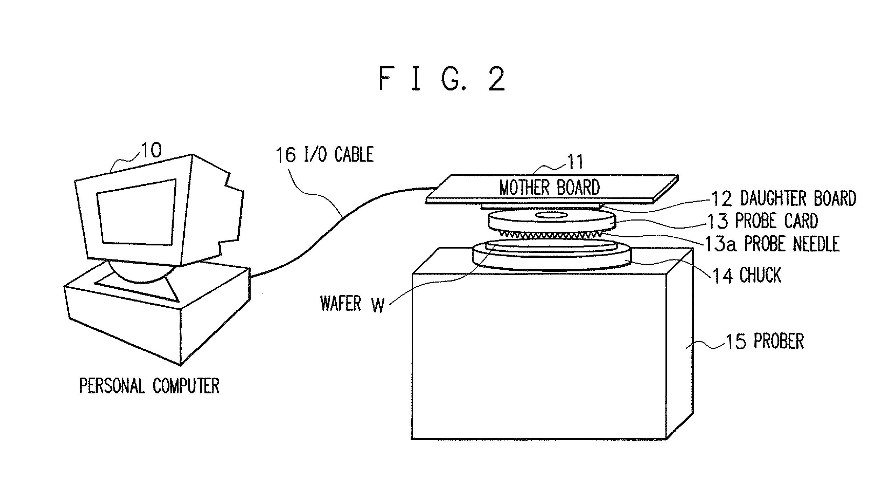

A first embodiment according to the present invention will be described below with reference to the drawings. Figure 2 shows an exemplary schematic configuration of the entire test system according to the first embodiment. As shown in Figure 2, the test system according to the first embodiment includes a personal computer 10, a mother board 11, a daughter board 12, a probe card 13, a chuck 14 and a prober 15. The probe card 13 has a plurality of probe needles 13a disposed thereon.

The wafer W to be tested is placed on the chuck 14 formed on the prober 15, and the probe needles 13a of the probe card 13 are moved to touch input/output terminals of an LSI formed on the wafer W. The probe card 13 is connected to the mother board 11 via the daughter board 12, and the mother board 11 is connected to the personal computer 10 via an I/O cable 16. Although the mother board 11 is directly connected to the personal computer 10 by the I/O cable 16 in this embodiment, the connection may be achieved via a network, such as the Internet or a LAN (Local Area Network).

The daughter board 12 is electrically connected to the mother board 11 and the probe card 13 in a removable manner. By exchanging the daughter board 12 according to the LSI to be tested, LSIs designed in different standards can be handled in a flexible manner.

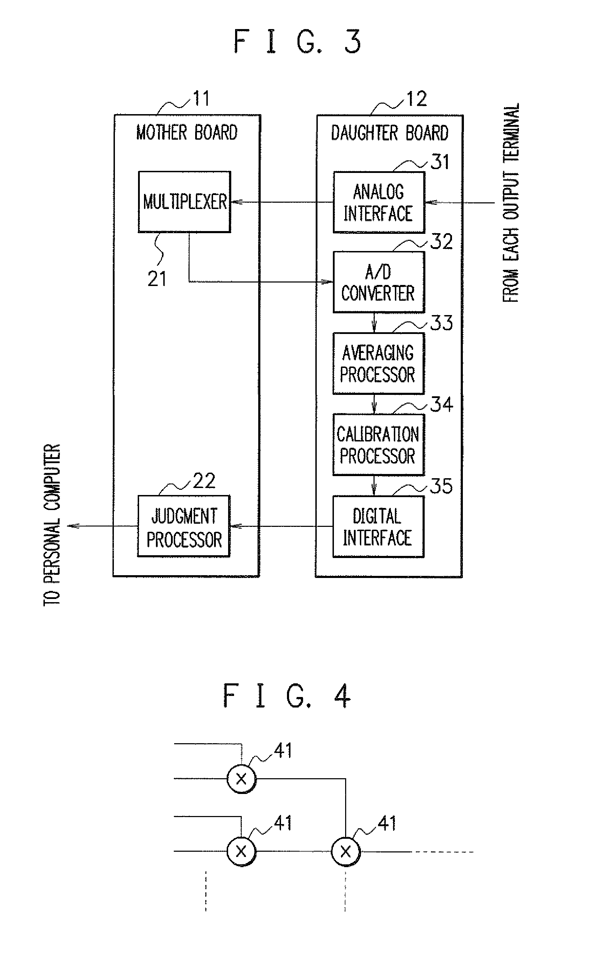

Figure 3 is a block diagram showing an exemplary inner configuration of the mother board 11 and the daughter board 12. As shown in Figure 3, the mother board 11 includes a multiplexer 21 and a judgment processor 22. The daughter board 12 includes an analog interface 31, an A/D (Analog/Digital) converter 32, an averaging processor 33, a calibration processor 34 and a digital interface 35.

The analog interface 31 on the daughter board 12 receives a plurality of analog signals outputted from a plurality of analog output terminals of the LSI formed on the wafer W via the probe card 13 and outputs them to the multiplexer 21 on the mother board 11. The inputted analog signals are voltage values outputted from the plurality of analog output terminals through an inner circuit of the LSI when test data are inputted to the LSI being tested.

The multiplexer 21 multiplexes the plurality of analog signals inputted from the analog interface 31 to reduce the number of signals and supplies the resultant signals to the A/D converter 32 on the daughter board 12. The A/D converter 32 converts the analog signals returned from the multiplexer 21 on the mother board 11 into digital data.

The averaging processor 33 averages digital data (digitized voltage values) sampled multiple times by the A/D converter 32. The averaging can reduce random errors of the voltage values resulting from the noise generated in the LSI being tested. Averaging in an early stage after the A/D conversion reduces the amount of data, making the following processing easier.

The calibration processor 34 reduces systematic errors generated in the LSI (the noise that is not random but having a certain tendency). For example, the calibration processor 34 subtracts a predetermined offset value from the digital data value outputted from the averaging processor 33. The offset value to be set in this case is an appropriate value as the amount of shift from the expectation value of the voltage to be outputted from the output terminal upon the input of the test data to the LSI.

The digital interface 35 receives the digital data calibrated by the calibration processor 34 and outputs it to the mother board 11. The judgment processor 22 on the mother board 11 performs pass/fail judgment on the LSI being tested based on the digital data inputted from the digital interface 35 and outputs the result to the personal computer 10 via the I/O cable 16.

As shown in Figure 4, the multiplexer 21 has a plurality of transistor switches 41 connected in a tournament manner. The plurality of analog signals outputted from the plurality of analog output terminals of the LSI via the probe card 13 successively pass through the plurality of transistor switches 41 so that the analog signals are multiplexed, allowing reduction in the number of signals. For example, when the LSI being tested has 1000-pin outputs (for example, source: 720 pins, gate: 320 pins), the 1000 analog signals outputted from the 1000 pins are multiplexed into one source analog signal and one gate analog signal.

In general, when a plurality of transistor switches are connected in a tournament manner, a transistor switch at a later stage also receives the load on a plurality of preceding transistor switches. Therefore, the later the transistor switch is disposed, the larger the amount of load on the transistor switch is. When a large number of transistor switches are connected in a tournament manner, the large load thus generated causes reduction in the operation speed of the multiplexer 21. In this embodiment, relay switches are provided at several locations where the transistor switches are disposed and these relay switches are turned on and off. When one of the relay switches is turned off, the load on the transistor switch connected to the preceding stage can be separated to reduce the amount of load on the transistor switch connected to the subsequent stage. This increases the operation speed of the multiplexer 21. In this embodiment, the multiplexing operation for 1000-pin outputs can be completed in a period of time as short as about 1 ms.

As the A/D converter 32 that A/D converts the analog signal multiplexed at high speed, a high-speed A/D converter operating at a speed comparable to that of the multiplexer 21, which is 100 ns, is used. The A/D converter 32 to be employed has a conversion accuracy of 12 bits, for example. Thus, while each of the 1000 analog signals outputted from the plurality of analog output terminals of the LSI being tested are sampled ten times for averaging, the averaged signal can be converted into 12-bit accuracy digital data in a period of time as short as about 1 ms.

In this embodiment, the analog signals outputted from each of the output terminals after inputting the same test data to the LSI are sampled, for example, ten times by the A/D converter 32 and the results are averaged by the averaging processor 33. The averaging reduces the effect of noise superimposed on each of the analog signals, so that highly accurate characteristic measurement data can be acquired. As described above, sampling 1000-pin analog signals once requires only about 100 µs. Characteristic measurement data is then obtained by averaging the digital data sampled ten times, so that the measuring time will be about 1 ms in total. This is a significantly short period of time compared to about 1 second conventionally required for one test, allowing significant reduction in test time compared to that conventionally required.

That is, conventionally, the tester body 101 is connected to the test head 102 by the dedicated cable 106 as shown in Figure 1, and a large amount of data is sent via the dedicated cable 106 for data processing in the tester body 101. Thus, not only does the limitation of the transfer speed through the dedicated cable 106 affects the test time but also the pass/fail judgment of the LSI needs to use the large amount of data sent to the tester body 101, so that a large amount of time is required for one test.

In contrast, in this embodiment, wiring is only used on the substrates, that is, the mother board 11 and the daughter board 12, and the high-speed multiplexer 21 and the high-speed A/D converter 32 are used. This allows multiplexing and A/D conversion to be performed in a period of time as short as about 100 ns, so that the processing frequency can be increased to about 10 MHz. Even when sampling is performed ten times for averaging in order to increase the accuracy of measured data, total processing time is significantly short, which is only about 1 ms. Furthermore, the number of signals outputted from the daughter board 12 to the judgment processor 22 on the mother board 11 is significantly reduced by the multiplexing process in the early stage and the amount of data is reduced by the averaging process in the averaging processor 33 in the relatively early stage after the A/D conversion, allowing the throughput to be improved.

As described above in detail, according to the first embodiment, the test for electric characteristics of a super multi-pin output LSI (such as a gate driver test and a source driver test for measuring driver voltages) can be carried out in a quick and highly accurate manner. Furthermore, since the plurality of analog signals outputted from the plurality of output terminals of the LSI are multiplexed in the early stage to reduce the number of signals and the digital data are averaged in the early stage after the A/D conversion to reduce the amount of data, a large number of parallel transportation paths and processing circuits are not required, allowing significant reduction in the scale of the configuration of the test system compared to that conventionally required.

### (Second Embodiment)

A second embodiment of the present invention will be described below with reference to the drawings. The whole configuration of the test system according to the second embodiment is the same as that shown in Figure 2.

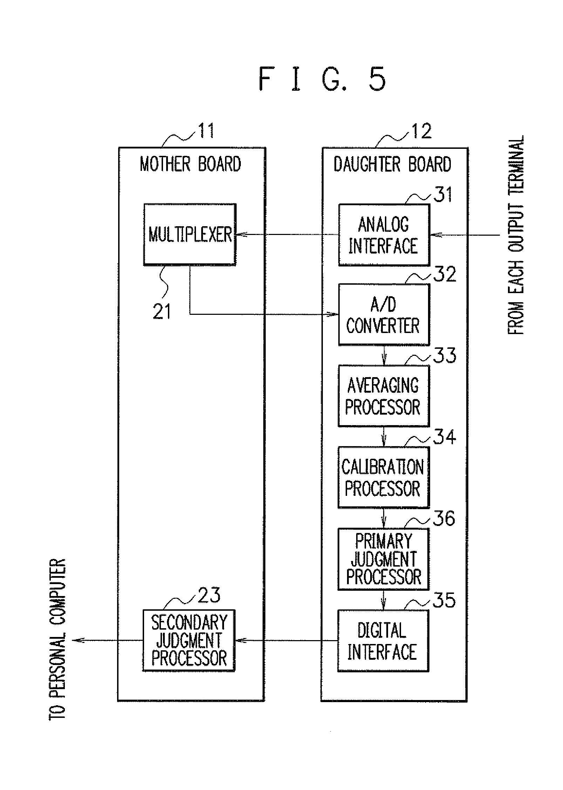

Figure 5 is a block diagram showing an exemplary inner configuration of the mother board 11 and the daughter board 12 according to the second embodiment. In Figure 5, since the components having the same reference characters as those shown in Figure 3 have the same functions, redundant description thereof will be omitted.

As shown in Figure 5, the mother board 11 according to the second embodiment includes a secondary judgment processor 23 instead of the judgment processor 22 shown in Figure 3. The daughter board 12 according to the second embodiment further includes a primary judgment processor 36 between the calibration processor 34 and the digital interface 35.

The primary judgment processor 36 performs primary pass/fail judgment on the digital data calibrated by the calibration processor 34 to eliminate unnecessary data. In this process, for example, when the calibration processor 34 subtracts a predetermined offset value from the digital data value and the resultant computed data value still significantly differs from the expectation value (for example, when the difference between the data value outputted from the calibration processor 34 and the expectation value is equal to or greater than a predetermined value), the primary judgment processor 36 judges that the LSI being tested is defective and discards the data.

In the second embodiment, the digital interface 35 outputs only digital data judged to be passed in the primary pass/fail judgment performed in the primary judgment processor 36 to the mother board 11.

The secondary judgment processor 23 on the mother board 11 performs secondary pass/fail judgment on the LSI being tested based on the digital data inputted from the digital interface 35 and outputs the result to the personal computer 10 via the I/O cable 16. The secondary pass/fail judgment performed in the secondary judgment processor 23 is similar to the pass/fail judgment performed in the judgment processor 22 shown in Figure 3 and a more advanced process than the primary pass/fail judgment performed in the primary judgment processor 36. Therefore, the pass/fail judgment performed in the secondary judgment processor 23 takes longer than the pass/fail judgment performed in the primary judgment processor 36.

As described above in detail, in the second embodiment, by performing the simple pass/fail judgment before the advanced pass/fail judgment is performed, LSIs being tested and apparently considered to be defective will not undergo further testing. That is, only digital data that have passed the primary pass/fail judgment performed in the primary judgment processor 36 are sent to the secondary judgment processor 23 for the secondary pass/fail judgment, so that it is possible to reduce the amount of digital data to be sent to the secondary judgment processor 23 where testing takes a longer period of time. This allows further improved throughput, faster processing and significant reduction in test time, compared to the first embodiment described above.

### (Third Embodiment)

A third embodiment of the present invention will be described below with reference to the drawings. In the first and second embodiments described above, the voltage values outputted from the analog output terminals after test data are inputted to the LSI to be tested are used as reference values to test the LSI. In contrast, in the third embodiment that will be described below, temporal shifts (such as response time) of digital data outputted from digital output terminals after pulse-like digital data are inputted to the LSI are used as reference values to test the LSI (so-called timing test).

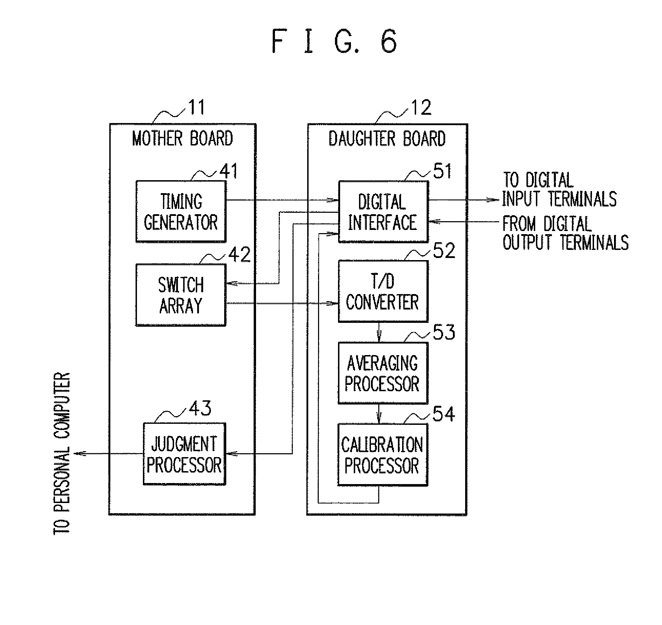

The whole configuration of the test system according to the third embodiment is the same as that shown in Figure 2. Figure 6 is a block diagram showing an exemplary inner configuration of the mother board 11 and the daughter board 12 according to the third embodiment.

As shown in Figure 6, the mother board 11 according to the third embodiment includes a timing generator 41, a switch array 42 and a judgment processor 43. The daughter board 12 according to the third embodiment includes a digital interface 51, a T/D (Time/Digital) converter 52, an averaging processor 53 and a calibration processor 54.

The timing generator 41 on the mother board 11 generates digital input signals (for example, pulse signals, each having a rising edge and a falling edge at a predetermined timing) supplied to the LSI being tested and outputs them to the digital interface 51 on the daughter board 12. The digital interface 51 outputs the digital input signals supplied from the timing generator 41 to the digital input terminals of the LSI and receives resultant digital output signals (characteristic measurement data of the LSI) returned from the digital output terminals of the LSI. Then, the digital data inputted from the LSI are outputted to the switch array 42 on the mother board 11.

The switch array 42 switches multiple pieces of digital data inputted from the digital interface 51 and supplies them to the T/D converter 52 on the daughter board 12. In this embodiment, the multiplexer is replaced with the switch array 42. The reason for this is that the number of the digital output terminals is not so large that the switch array 42 having an array of relay switches has enough ability to handle the multiple pieces of digital data. When the number of the digital output terminals is so large that the number of the digital data values to be inputted to the digital interface 51 is enormous, the switch array 42 may be replaced with a multiplexer. In this case, the multiplexer may be configured by combining transistor switches and relay switches, as in the multiplexer 21 shown in Figure 3. When the switch array 42 is used, transistor switches are not connected in a tournament manner as in a multiplexer, so that a large load will not be applied, allowing a high speed operation.

The T/D converter 52 performs analog-to-digital conversion of the period of time spent from the time when the digital data are inputted from the digital interface 51 to the digital input terminals of the LSI to the time when the digital data are outputted from the digital output terminals of the LSI and inputted to the T/D converter 52 via the switch array 42 (the response time spent from the time when the pulse is inputted to the LSI to the time when resultant measured data is obtained).

The averaging processor 53 averages multiple pieces of digital data (digitized response time) obtained from the T/D converter 52. For example, digital signals outputted from the digital output terminals after the same pulse data are inputted to the LSI are used to digitize, for example, ten pieces of response time data in the T/D converter 52 and the results are averaged by the averaging processor 53. The averaging can reduce random errors of the response time data resulting from the noise generated in the LSI being tested. Averaging in an early stage reduces the amount of data, making the following processing easier.

The calibration processor 54 reduces systematic errors generated in the LSI being tested. For example, the calibration processor 54 subtracts a predetermined offset value from the digital data value corresponding to the response time outputted from the averaging processor 53. The offset value to be set in this case is an appropriate value as the amount of shift from the expectation value of the response time spent from the time when the digital data is inputted to the LSI to the time when resultant measured data is obtained. The digital data calibrated by the calibration processor 54 is supplied to the judgment processor 43 on the daughter board 12 via the digital interface 51.

The judgment processor 43 performs pass/fail judgment of the LSI being tested based on the digital data inputted from the digital interface 51 and outputs the result to the personal computer 10 via the I/O cable 16.

In the thus configured third embodiment, wiring is only used on the substrates, that is, the mother board 11 and the daughter board 12. The amount of data is reduced by the averaging process in the averaging processor 53 in the relatively early stage after the T/D conversion, allowing the throughput to be improved.

Therefore, it is possible to perform electric characteristic testing on a super multi-pin output LSI (timing test to investigate the response time and the like) in a quick and highly accurate manner. Furthermore, since the digital data are averaged in the early stage after the T/D conversion to reduce the amount of data, a large number of parallel transportation paths and processing circuits are not required, allowing significant reduction in the scale of the configuration of the test system compared to that conventionally required.

### (Fourth Embodiment)

A fourth embodiment of the present invention will be described below with reference to the drawings. The whole configuration of the test system according to the fourth embodiment is the same as that shown in Figure 2.

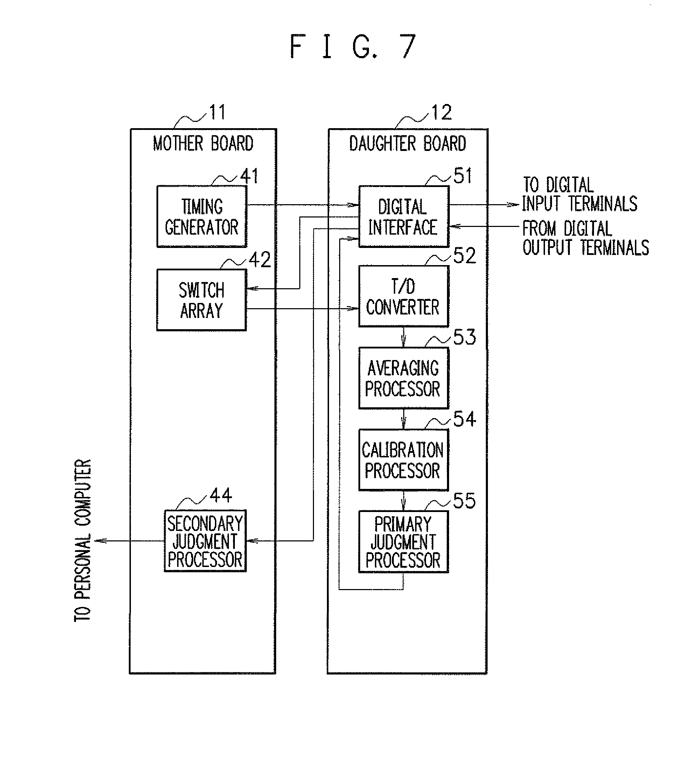

Figure 7 is a block diagram showing an exemplary inner configuration of the mother board 11 and the daughter board 12 according to the fourth embodiment. In Figure 7, components having the same reference characters as those shown in Figure 6 have the same functions and redundant description thereof will be omitted.

As shown in Figure 7, the mother board 11 according to the fourth embodiment includes a secondary judgment processor 44 instead of the judgment processor 43 shown in Figure 6. The daughter board 12 according to the second embodiment further includes a primary judgment processor 55 between the calibration processor 54 and the digital interface 51.

The primary judgment processor 55 performs primary pass/fail judgment on the digital data calibrated by the calibration processor 54 to eliminate unnecessary data. In this process, for example, when the calibration processor 54 subtracts a predetermined offset value from the digital data value and the resultant computed data value still significantly differs from the expectation value (for example, when the difference between the data value outputted from the calibration processor 54 and the expectation value is equal to or greater than a predetermined value), the primary judgment processor 55 judges that the LSI being tested is defective and discards the data.

In the fourth embodiment, the digital interface 51 outputs only digital data judged to be passed in the primary pass/fail judgment performed in the primary judgment processor 55 to the mother board 11.

The secondary judgment processor 44 on the mother board 11 performs secondary pass/fail judgment on the LSI being tested based on the digital data inputted from the digital interface 51 and outputs the result to the personal computer 10 via the I/O cable 16. The secondary pass/fail judgment performed in the secondary judgment processor 44 is similar to the pass/fail judgment performed in the judgment processor 43 shown in Figure 6 and a more advanced process than the primary pass/fail judgment performed in the primary judgment processor 55. Therefore, the pass/fail judgment performed in the secondary judgment processor 44 takes longer than the pass/fail judgment performed in the primary judgment processor 55.

As described above in detail, in the fourth embodiment, by performing the simple pass/fail judgment before the advanced pass/fail judgment is performed, LSIs being tested and apparently considered to be defective will not undergo further testing. That is, only digital data that have passed the primary pass/fail judgment performed in the primary judgment processor 55 are sent to the secondary judgment processor 44 for the secondary pass/fail judgment, so that it is possible to reduce the amount of digital data to be sent to the secondary judgment processor 44 where testing takes a longer period of time. This allows further improved throughput, faster processing and significant reduction in test time, compared to the third embodiment described above.

### (Fifth Embodiment)

A fifth embodiment of the present invention will be described below with reference to the drawings. The fifth embodiment is a combination of the second and fourth embodiments. The whole configuration of the test system according to the fifth embodiment is the same as that shown in Figure 2.

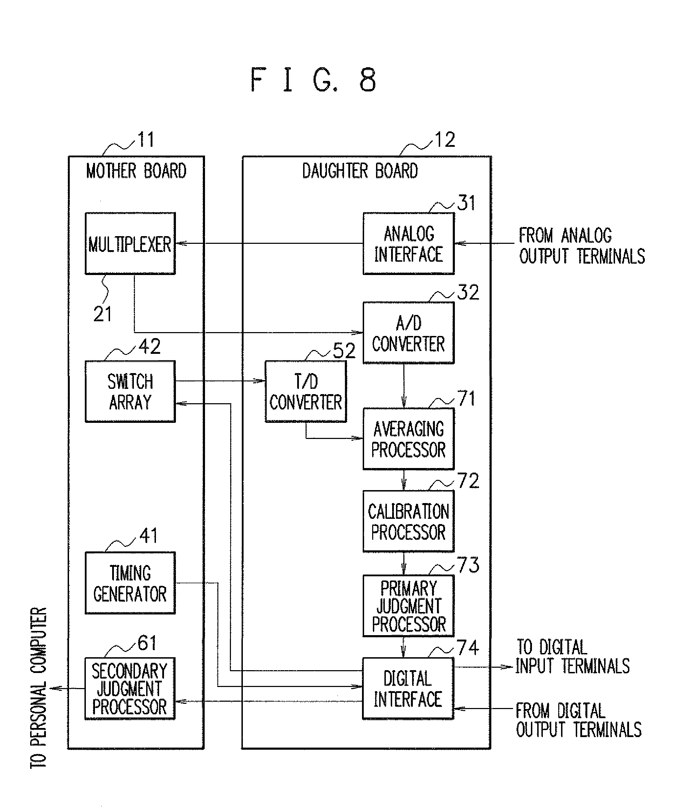

Figure 8 is a block diagram showing an exemplary inner configuration of the mother board 11 and the daughter board 12 according to the fifth embodiment. In Figure 8, components having the same reference characters as those shown in Figures 5 and 7 have the same functions and redundant description thereof will be omitted.

As shown in Figure 8, the mother board 11 according to the fifth embodiment includes the multiplexer 21, the timing generator 41, the switch array 42 and a secondary judgment processor 61. The daughter board 12 according to the fifth embodiment includes the analog interface 31, the A/D converter 32, the T/D converter 52, an averaging processor 71, a calibration processor 72, a primary judgment processor 73 and a digital interface 74.

The averaging processor 71 on the daughter board 12 has both functions of the averaging processor 33 shown in Figure 5 and the averaging processor 53 shown in Figure 7. That is, the averaging processor 71 averages digital data sampled multiple times by the A/D converter 32 (digitized voltage values obtained by inputting the test data to the LSI, which corresponds to first digital data of the present invention). The averaging processor 71 also averages multiple pieces of digital data obtained from the T/D converter 52 (digitized response time spent from the time when the pulse is inputted to the LSI to the time when resultant measured data is obtained, which corresponds to second digital data of the present invention).

The calibration processor 72 has both functions of the calibration processor 34 shown in Figure 5 and the calibration processor 54 shown in Figure 7. That is, the calibration processor 72 subtracts predetermined offset values from the digital data values outputted from the averaging processor 71. The offset values to be set in this case are appropriate values as the amount of shift from the expectation value of the voltage to be outputted from the output terminal upon the input of the test data to the LSI and the amount of shift from the expectation value of the response time spent from the time when the pulse is inputted to the LSI to the time when resultant measured data is obtained.

The primary judgment processor 73 has both functions of the primary judgment processor 36 shown in Figure 5 and the primary judgment processor 55 shown in Figure 7 and eliminates unnecessary data from the digital data calibrated by the calibration processor 72. That is, when the calibration processor 36 subtracts a first offset value for a voltage value from the first digital data value and the resultant computed data value still significantly differs from the expectation value, the primary judgment processor 73 judges that the LSI being tested is defective and discards the data. Furthermore, when the calibration processor 54 subtracts a second offset value for response time from the second digital data value and the resultant computed data value still significantly differs from the expectation value, the primary judgment processor 73 judges that the LSI being tested is defective and discards the data.

The digital interface 74 outputs only digital data judged to be passed in the primary pass/fail judgment performed in the primary judgment processor 73 to the mother board 11.

The secondary judgment processor 61 on the mother board 11 performs secondary pass/fail judgment on the LSI being tested based on the digital data inputted from the digital interface 74 and outputs the result to the personal computer 10 via the I/O cable 16. The secondary judgment processor 61 performs comprehensive judgment on the first digital data (digitized voltage values) outputted from the analog output terminals of the LSI, A/D converted and supplied from the primary judgment processor 73 and the second digital data (digitized response time) outputted from the digital output terminals of the LSI and supplied through the primary judgment processor 73.

The averaging processor 71, the calibration processor 72 and the primary judgment processor 73 described above can be formed, for example, by one DSP (Digital Signal Processor).

According to the thus configured fifth embodiment, the test for electric characteristics of a super multi-pin output LSI can be carried out in a quick and highly accurate manner in the test system capable of carrying out not only a driver test for measuring a driver voltage but also a timing test for investigating response time and the like. Furthermore, the configuration of the test system can be significantly smaller than that conventionally required. Moreover, the test system according to the fifth embodiment performs comprehensive judgment including the pass/fail judgment based on the analog signals outputted from the analog output terminals of the LSI and the pass/fail judgment based on the digital signals outputted from the digital output terminals of the LSI, allowing further highly accurate testing.

In the first to fifth embodiments, although the description has been made of the example where the mother board 11 and the daughter board 12 are separately provided and each function block is disposed on either of the boards, this is only one example showing the layout the functions. That is, it is quite arbitrarily determined which function block is provided on the mother board 11 or the daughter board 12. Furthermore, the mother board 11 and the daughter board 12 may not be separated, but may be integrated into one board.

In the first to fifth embodiments, although the description has been made of the example where the types of testing to be carried out are the driver test and the timing test, the present invention can be applied to other tests.

In the first to fifth embodiments, although the description has been made of the example where the tests are performed on a super multi-pin output LSI used in display apparatuses, such as liquid crystal displays, organic EL displays, plasma displays and field emission displays, semiconductors to be tested are not limited thereto.

The numerical values shown in the first to fifth embodiments are only by way of example, and the present invention is not limited thereto.

Furthermore, the above embodiments are presented only by way of example of how the present invention is specifically carried out, and should not be construed to limit the technical scope of the present invention. That is, the present invention can be implemented in various forms without departing from the spirit and major features thereof.

### [Industrial Applicability]

The present invention is useful for a test system for testing electric characteristic of a super multi-pin output LSI.

## Claims

1. A test system for a semiconductor that outputs analog signals from a plurality of output terminals, the test system comprises:
a multiplexer that multiplexes a plurality of analog signals outputted from the plurality of output terminals to reduce the number of signals;
an A/D converter that converts an analog signal outputted from the multiplexer into digital data;
an averaging processor that averages digital data sampled multiple times by the A/D converter;
a calibration processor that subtracts a predetermined offset value from the digital data value outputted from the averaging processor to eliminate systematic errors of the semiconductor; and
a judgment processor that performs pass/fail judgment on the semiconductor based on the digital data outputted from the calibration processor.

2. The test system for a semiconductor according to claim 1, the multiplexer includes:
a plurality of transistor switches connected in a tournament manner; and
relay switches provided at several locations where the plurality of transistor switches are disposed;
wherein the relay switches are turned on and off.

3. The test system for a semiconductor according to claim 1, the test system further comprises:
a primary judgment processor that performs primary pass/fail judgment on the semiconductor based on the digital data outputted from the calibration processor;
wherein the judgment processor performs secondary pass/fail judgment based on the digital data judged to be passed in the primary pass/fail judgment performed in the primary judgment processor.

4. A test system for a semiconductor that outputs digital signals from a plurality of output terminals, the test system comprises:
a T/D converter that converts response time required to obtain the digital signals outputted from the plurality of output terminals into digital data;
an averaging processor that averages digital data sampled multiple times by the T/D converter;
a calibration processor that subtracts a predetermined offset value from the digital data value outputted from the averaging processor to eliminate systematic errors of the semiconductor; and
a judgment processor that performs pass/fail judgment on the semiconductor based on the digital data outputted from the calibration processor.

5. The test system for a semiconductor according to claim 4, the test system further comprises:
a primary judgment processor that performs primary pass/fail judgment on the semiconductor based on the digital data outputted from the calibration processor;
wherein the judgment processor performs secondary pass/fail judgment based on the digital data judged to be passed in the primary pass/fail judgment performed in the primary judgment processor.

6. A test system for a semiconductor that outputs analog signals from a plurality of analog output terminals and digital signals from a plurality of digital output terminals, the test system comprises:
a multiplexer that multiplexes a plurality of analog signals outputted from the plurality of analog output terminals to reduce the number of signals;
an A/D converter that converts an analog signal outputted from the multiplexer into first digital data;
a T/D converter that converts response time required to obtain the digital signals outputted from the plurality of digital output terminals into second digital data;
an averaging processor that averages the first digital data sampled multiple times by the A/D converter and the second digital data sampled multiple times by the T/D converter;
a calibration processor that subtracts a first offset value from the first digital data value outputted from the averaging processor and subtracts a second offset value from the second digital data value outputted from the averaging processor so as to eliminate systematic errors of the semiconductor; and
a judgment processor that performs pass/fail judgment on the semiconductor based on the first and second digital data outputted from the calibration processor.

7. The test system for a semiconductor according to claim 6, the test system further comprises:
a primary judgment processor that performs primary pass/fail judgment on the semiconductor based on the first and second digital data outputted from the calibration processor;
wherein the judgment processor performs secondary pass/fail judgment based on the first and second digital data judged to be passed in the primary pass/fail judgment performed in the primary judgment processor.

8. A test system for a semiconductor that outputs analog signals from a plurality of output terminals, the test system comprises:
a probe card having probe needles that are moved to touch the plurality of output terminals;
a mother board connected to an external computer or a network; and
a daughter board removably connected between the probe card and the mother board;
wherein the mother board or the daughter board includes:
an analog interface that receives a plurality of analog signals outputted from the plurality of output terminals through the probe card and outputs the plurality of analog signals,
a multiplexer that multiplexes the plurality of analog signals inputted from the analog interface to reduce the number of signals,
an A/D converter that converts an analog signal outputted from the multiplexer into digital data,
an averaging processor that averages digital data sampled multiple times by the A/D converter,
a calibration processor that subtracts a predetermined offset value from the digital data value outputted from the averaging processor to eliminate systematic errors of the semiconductor,
a digital interface that receives the digital data outputted from the calibration processor and outputs the digital data, and
a judgment processor that performs pass/fail judgment on the semiconductor based on the digital data inputted from the digital interface.

9. The test system for a semiconductor according to claim 8, the multiplexer includes:
a plurality of transistor switches connected in a tournament manner; and
relay switches provided at several locations where the plurality of transistor switches are disposed;
wherein the relay switches are turned on and off.

10. A test system for a semiconductor that outputs digital signals from a plurality of output terminals, the test system comprises:
a probe card having probe needles that are moved to touch the plurality of output terminals;
a mother board connected to an external computer or a network; and
a daughter board removably connected between the probe card and the mother board;
wherein the mother board or the daughter board includes:
a digital interface that receives a plurality of digital signals outputted from the plurality of output terminals through the probe card and outputs the plurality of digital signals,
a T/D converter that converts response time required to obtain the digital signals inputted from the digital interface into digital data,
an averaging processor that averages digital data sampled multiple times by the T/D converter,
a calibration processor that subtracts a predetermined offset value from the digital data value outputted from the averaging processor to eliminate systematic errors of the semiconductor and supplies the result to the digital interface, and
a judgment processor that performs pass/fail judgment on the semiconductor based on the calibrated digital data inputted from the digital interface.

11. The test system for a semiconductor according to any one of claims 8 to 10, the test system further comprises:
a primary judgment processor that performs primary pass/fail judgment on the semiconductor based on the digital data outputted from the calibration processor;
wherein the judgment processor performs secondary pass/fail judgment based on the digital data judged to be passed in the primary pass/fail judgment performed in the primary judgment processor.
